# EUROPÄISCHE PATENTANMELDUNG

(11) **EP 4 800 405 A1**
(43) Veröffentlichungstag der Anmeldung: **02.09.2026**
(21) Anmeldenummer: 26156163.3
(22) Anmeldetag: 03.02.2026
(51) Int. Cl.: G01R 31/3832, G01R 31/387

(54) **MESSVORRICHTUNG DER RESTLADUNGSMENGE MINDESTENS EINER BATTERIE UND EINE SOLCHE MESSVORRICHTUNG ENTHALTENDER FLUID- UND/ODER WÄRMEENERGIEZÄHLER**

(30) Priorität: 26.02.2025 FR 2501943
(71) Anmelder: DIEHL METERING SAS, 68304 Saint Louis (FR)
(72) Erfinder: Dr. Bach, Guy, Waldighofen (FR); Dockwiller, Bernard, Saint-Bernard (FR); Perrin, Eric, Obermorschwihr (FR)
(74) Vertreter: Diehl Patentabteilung

(57) **Zusammenfassung**

Messvorrichtung der Restladungsmenge mindestens einer Batterie und eine solche Messvorrichtung enthaltender Fluid- und/oder Wärmeenergiezähler

Die Erfindung betrifft eine Messvorrichtung der Restladungsmenge einer Batterie (1), die enthält: einen Gleichstrom-Gleichstrom-Wandler (2), der konfiguriert ist, aus der Batterie (1) eine Ladungsmenge während der Messdauer zu entnehmen, und einen Mikrocontroller (4), dadurch gekennzeichnet, dass:
- der Mikrocontroller (4) ein Zählmodul (5) und ein Verarbeitungsmodul (7) enthält,
- die Messvorrichtung außerdem eine Impulsformerstufe (8) enthält,
- das Zählmodul (5) konfiguriert ist, die Anzahl von Impulsen des von der Impulsformerstufe (8) geformten Impulsfolgesignals zu zählen, und
- das Verarbeitungsmodul (7) konfiguriert ist, ausgehend von der durch das Zählmodul (5) erhaltenen Anzahl von Impulsen die Restladungsmenge der mindestens einen Batterie (1) während der Messdauer zu bestimmen.

## Beschreibung

Die vorliegende Erfindung betrifft das Gebiet der Vorrichtungen zur Messung der Restladungsmenge mindestens einer Batterie und das Gebiet der Fluid- und/oder Wärmeenergiezähler.

Bei einem elektronischen Gerät ist es oft notwendig, die von der Batterie oder den Batterien gelieferte Spannung an die Betriebsspannung der elektronischen Schaltung anzupassen. Dies erfolgt häufig mit einem DC/DC-Wandler hoher Wirksamkeit. Für ein elektronisches Gerät kann es sehr wichtig sein, den Restladungszustand der Batterie oder der Batterien zu kennen. Wenn die Batterie oder die Batterien diese Information nicht liefern, was bei den Primärbatterien immer der Fall ist, kann sie nicht berechnet werden. Hierzu muss die elektronische Schaltung die Anfangsladung der Batterie oder der Batterien kennen, von der ausgehend sie alle von der Batterie oder den Batterien während der ganzen Lebensdauer gelieferten Ladungen subtrahiert. Um die von der Batterie oder den Batterien gelieferten Ladungen zu erfahren, ist es üblich, ihren Ausgangsstrom zu messen und den Wert mit der Messperiode zu multiplizieren. Dieses Verfahren erfordert Verarbeitungsressourcen, verbraucht Strom und ist teuer.

Um die Restladungsmenge mindestens einer Batterie zu messen, ist es zum Beispiel bekannt, einen Shunt-Widerstand zu verwenden. Der Strom wird mit dem einer hochdynamischen elektronischen Schaltung zugeordneten Shunt-Widerstand gemessen, dann werden die Daten in Echtzeit digital verarbeitet. Diese Echtzeitverarbeitung ist besonders kritisch, da sie Energie verbraucht.

Die Veröffentlichung US2018180699A1 offenbart ein Gerät, das enthält: einen DC-DC-Wandler mit Impulsfrequenzmodulation, eine Logik, die es ermöglicht, auf der Basis eines Abgleichvorgangs eine Abgleichladung zu bestimmen, die durch Impuls an einer Batterie entnommen wird, die eine Eingangsspannung an den Wandler mit Impulsfrequenzmodulation liefert, eine Abgleichstromladung, die gesteuert wird, um zu einer Stromladung des Systems während mindestens eines Teils des Abgleichvorgangs hinzugefügt zu werden, um eine vom Wandlers wahrgenommene erhöhte Stromladung zu liefern, einen Zähler, um eine Anzahl von Impulsen zu zählen, die Schaltereignissen entsprechen, die im Wandler während des einer Betriebsbatteriespannung zugeordneten Betriebs eintreten, und wobei die Logik konfiguriert ist, die an der Batterie während der Anzahl von Impulsen entnommene Ladung zu bestimmen, basierend zumindest zum Teil auf der Betriebsspannung der Batterie, der durch Impuls entnommenen Abgleichladung und der Anzahl von Impulsen. Dieses Gerät hat aber den Nachteil, eine aktive elektronische Schaltung zu erfordern, die es ermöglicht, die Impulse stromaufwärts vor der Logik zu zählen, die den Nachteil hat, komplex und teuer in der Ausführung zu sein.

Die vorliegende Erfindung hat zum Ziel, mindestens einen dieser Nachteile zu beseitigen und will eine Lösung vorschlagen, die es zumindest ermöglicht, die Restladungsmenge mindestens einer Batterie mit geringem Verbrauch elektrischer Energie und auf vereinfachte Weise zu messen.

Zu diesem Zweck betrifft die Erfindung eine Vorrichtung zum Messen der Restladungsmenge mindestens einer Batterie, die mindestens enthält:
- einen Gleichstrom-Gleichstrom-Schaltwandler, der konfiguriert ist, eine von der mindestens einen Batterie kommende Eingangsspannung in eine Ausgangsspannung umzuwandeln, und am Ausgang ein Impulsfolgesignal liefert, wobei der Gleichstrom-Gleichstrom-Wandler konfiguriert ist, aus der mindestens einen Batterie eine Ladungsmenge während der Messdauer zu entnehmen, die einer Anzahl von Impulsen des Impulsfolgesignals entspricht,
- eine Steuereinheit, die elektrisch mit dem Gleichstrom-Gleichstrom-Wandler verbunden ist und mindestens einen Mikrocontroller enthält,
wobei die Messvorrichtung dadurch gekennzeichnet ist, dass:
- der mindestens eine Mikrocontroller ein Zählmodul enthält, das einen Zähleingang hat, und der mindestens eine Mikrocontroller ein elektrisch mit dem Zählmodul verbundenes Verarbeitungsmodul enthält,
- die Messvorrichtung außerdem eine Impulsformerstufe enthält, die elektrisch mit dem Ausgang und mit dem Zähleingang verbunden und konfiguriert ist, das Impulsfolgesignal zu begrenzen, um es zu formen, damit es mit dem Zähleingang kompatibel ist,
- das Zählmodul konfiguriert ist, die Anzahl von Impulsen des von der Impulsformerstufe geformten Impulsfolgesignals zu zählen, und
- das Verarbeitungsmodul konfiguriert ist, mindestens ausgehend von der vom Zählmodul erhaltenen Anzahl von Impulsen die Restladungsmenge der mindestens einen Batterie während der Messdauer zu bestimmen.

Die Erfindung betrifft ebenfalls einen Fluid- und/oder Wärmeenergiezähler, der mindestens die mindestens eine Batterie und eine Messvorrichtung der Restladungsmenge der mindestens einen Batterie enthält, dadurch gekennzeichnet, dass die Messvorrichtung erfindungsgemäß ist.

Die Erfindung betrifft ebenfalls ein festklippbares Modul, das mindestens die mindestens eine Batterie und eine Messvorrichtung der Restladungsmenge der mindestens einen Batterie enthält, dadurch gekennzeichnet, dass die Messvorrichtung der Erfindung entspricht.

Die Erfindung wird besser verstanden dank der nachfolgenden Beschreibung, die sich auf mehrere bevorzugte Ausführungsformen bezieht, die als nicht einschränkende Beispiele angegeben und unter Bezug auf die beiliegenden schematischen Zeichnungen erläutert werden, in denen:
Figur 1 eine schematische Ansicht der erfindungsgemäßen Messvorrichtung darstellt,
Figur 2 drei Kurven darstellt, die den Betrieb des Verarbeitungsmoduls gemäß einer ersten Möglichkeit veranschaulichen, und
Figur 3 drei Kurven darstellt, die den Betrieb des Verarbeitungsmoduls gemäß einer zweiten Möglichkeit veranschaulichen.

Die Vorrichtung zum Messen der Restladungsmenge BC mindestens einer Batterie 1 enthält mindestens:
- einen Gleichstrom-Gleichstrom-Schaltwandler 2, der konfiguriert ist, eine von der mindestens einen Batterie 1 kommende Eingangsspannung U1 in eine Ausgangsspannung U2 umzuwandeln, und an einem zusätzlichen Ausgang S' ein Impulsfolgesignal liefert, wobei der Gleichstrom-Gleichstrom-Wandler 2 konfiguriert ist, aus der mindestens einen Batterie 1 eine Ladungsmenge während der Messdauer zu entnehmen, die einer Anzahl von Impulsen des Impulsfolgesignals entspricht,
- eine Steuereinheit 3, die elektrisch mit dem Gleichstrom-Gleichstrom-Wandler 2 verbunden ist und mindestens einen Mikrocontroller 4 enthält.

Erfindungsgemäß ist die Messvorrichtung dadurch gekennzeichnet, dass:
- der mindestens eine Mikrocontroller 4 ein Zählmodul 5 enthält, das einen Zähleingang 6 hat, und der mindestens eine Mikrocontroller 4 ein elektrisch mit dem Zählmodul 5 verbundenes Verarbeitungsmodul 7 enthält,
- die Messvorrichtung außerdem eine Impulsformerstufe 8 enthält, die elektrisch mit dem zusätzlichen Ausgang S' und mit dem Zähleingang 6 verbunden und konfiguriert ist, das Impulsfolgesignal zu begrenzen, um es zu formen, damit es mit dem Zähleingang 6 kompatibel ist,

- das Zählmodul 5 konfiguriert ist, die Anzahl von Impulsen des von der Impulsformerstufe 8 geformten Impulsfolgesignals zu zählen, und
- das Verarbeitungsmodul 7 konfiguriert ist, mindestens ausgehend von der vom Zählmodul 5 erhaltenen Anzahl von Impulsen die Restladungsmenge BC der mindestens einen Batterie 1 während der Messdauer zu bestimmen.

Vorteilhafterweise ermöglicht die vorliegende Erfindung, die Restladungsmenge BC mindestens einer Batterie 1 während mindestens der Messdauer zu messen, indem einfach die aus dem Gleichstrom-Gleichstrom-Wandler 2 austretenden Impulse geformt werden, um sie direkt mit Hilfe des Zählmoduls 5 auszuwerten, das bereits ursprünglich im Mikrocontroller 4 vorhanden ist. Indem so ein Mikrocontroller 4 gewählt wird, der ursprünglich das Zählmodul 5 enthält, genügt es, die Impulsformerstufe 8 hinzuzufügen und das Verarbeitungsmodul 7 des Mikrocontrollers 4 adäquat zu konfigurieren, um die Restladungsmenge BC mindestens einer Batterie 1 während der Messdauer zu messen. Dank der Erfindung resultieren daraus ein begrenzter Energieverbrauch und eine Vereinfachung der Messvorrichtung.

Vorzugsweise enthält die Impulsformerstufe 8 mindestens eine passive analoge Schaltung ohne Steuerlogik.

Vorteilhafterweise ist die Impulsformerstufe 8 eine einfache und passive analoge Schaltung, was die Herstellungskosten und den Stromverbrauch begrenzt. Unter einer passiven analogen Schaltung wird zum Beispiel eine elektronische Schaltung verstanden, die weder eine eigene Versorgungsquelle noch elektronische Bauteile enthält, die über eine Logikeinheit der Art Mikrocontroller verfügen.

Vorzugsweise enthält die Impulsformerstufe 8 mindestens einen Spannungsbegrenzer.

Vorteilhafterweise ermöglicht der Spannungsbegrenzer, die Amplitude des Impulsfolgesignals am Ausgang des Gleichstrom-Gleichstrom-Wandlers 2 zu begrenzen.

Vorzugsweise enthält das Verarbeitungsmodul 7 einen Kalibrierungsparameter NC, der vorzugsweise nach einem Kalibrierungsvorgang in einem Speicher (nicht dargestellt) vorab eingespeichert wird, den die Messvorrichtung enthält, der elektrisch mit dem Verarbeitungsmodul 7 verbunden ist, wobei der Kalibrierungsparameter NC einer Anzahl von Kalibrierungsimpulsen NBPC entspricht, um eine Kalibrierungsladungsmenge NBCC aus der mindestens einen Batterie 1 zu entnehmen.

Vorteilhafterweise ermöglicht der Kalibrierungsparameter NC, eine Messung zu erhalten, die zuverlässig ist, indem ein einfacher Kalibrierungsvorgang zum Beispiel zum Zeitpunkt der Herstellung der Messvorrichtung oder später durchgeführt wird.

Vorzugsweise und gemäß einer ersten Möglichkeit, während der Messdauer und iterativ, ist das Zählmodul 5 konfiguriert, jedes Mal, wenn der Wert der erhaltenen Anzahl von Impulsen NBP die Anzahl von Kalibrierungsimpulsen NBPC erreicht, diese Information an das Verarbeitungsmodul 7 zu kommunizieren, damit das Verarbeitungsmodul 7 konfiguriert ist, vom vorhergehenden Wert der Restladungsmenge BC der mindestens einen Batterie 1 die Kalibrierungsladungsmenge NBCC zu subtrahieren.

Vorteilhafterweise erfordert dieses Verarbeitungsprinzip eine schnelle Reaktivität des Mikrocontrollers 4, aber minimale Rechenressourcen zur Messung der Restladungsmenge BC der mindestens einen Batterie 1.

Das Zählmodul 5 kann ebenfalls konfiguriert sein, den Wert der erhaltenen Anzahl von Impulsen auf Null zurückzusetzen, wenn die Anzahl von Kalibrierungsimpulsen NBPC erreicht ist.

Vorzugsweise und gemäß einer zweiten Möglichkeit, während der Messdauer und iterativ, ist das Verarbeitungsmodul 7 konfiguriert, den Wert der zu einem gegebenen Zeitpunkt Ni erhaltenen Anzahl von Impulsen auszulesen, ist das Verarbeitungsmodul 7 konfiguriert, die zu einem gegebenen Zeitpunkt Ni erhaltene Anzahl von Impulsen, zu der der Rest der Division der vorhergehenden Iteration hinzugefügt wird, durch die Anzahl von Kalibrierungsimpulsen NBPC zu dividieren, dann vom vorhergehenden Wert der Restladungsmenge BC der mindestens einen Batterie 1 die Kalibrierungsladungsmenge NBCC zu subtrahieren, mit der bei der Division erhaltenen ganzen Zahl zu multiplizieren, dann den Rest der Division für die folgende Iteration beizubehalten.

Vorteilhafterweise erfordert dieses Verarbeitungsprinzip etwas mehr Rechenressourcen von Seiten des Mikrocontrollers 4, ist aber nicht zeitabhängig.

Vorteilhafterweise wird bei diesen zwei erwähnten Konfigurationen zur Messung der Restladungsmenge BC der mindestens einen Batterie 1 jeder Impuls berücksichtigt, ohne deswegen eine Echtzeitverarbeitung durch das Verarbeitungsmodul 7 des Mikrocontrollers 4 zu erfordern, wie es im Stand der Technik der Fall ist.

Vorzugsweise enthält die Messvorrichtung außerdem eine drahtlose Kommunikationseinheit, vorzugsweise Radiofrequenz und/oder NFC, die elektrisch mit der Steuereinheit 3 verbunden ist.

Vorteilhafterweise ermöglicht die drahtlose Kommunikationseinheit, drahtlos nach außerhalb der Messvorrichtung und/oder umgekehrt zu kommunizieren, um mindestens das Auslesen der Restladungsmenge BC der mindestens einen Batterie 1 zu ermöglichen und ggf. das Einschreiben oder Auslesen des Kalibrierungsparameters NC zu ermöglichen.

Vorzugsweise enthält die Messvorrichtung außerdem eine Mensch-Maschine-Schnittstelle, die elektrisch mit der Steuereinheit 3 verbunden ist.

Vorteilhafterweise ermöglicht die Mensch-Maschine-Schnittstelle, nach außerhalb der Messvorrichtung und/oder umgekehrt zu kommunizieren, um mindestens das Auslesen der Restladungsmenge BC der mindestens einen Batterie 1 zu ermöglichen und ggf. das Einschreiben oder das Auslesen des Kalibrierungsparameters NC zu ermöglichen.

Die Erfindung betrifft ebenfalls einen Fluid- und/oder Wärmeenergiezähler, der mindestens die mindestens eine Batterie 1 und eine Messvorrichtung der Restladungsmenge BC der mindestens einen Batterie 1 enthält, dadurch gekennzeichnet, dass die Messvorrichtung gemäß der Erfindung und wie oben beschrieben ist.

Vorteilhafterweise findet die erfindungsgemäße Messvorrichtung insbesondere Anwendung auf dem Gebiet der Fluidzähler und/oder auf dem Gebiet der Wärmeenergiezähler. Diese Anwendungsgebiete sind selbstverständlich nicht einschränkend zu verstehen.

Die Erfindung betrifft ebenfalls ein festklippbares Modul, das mindestens die mindestens eine Batterie 1 und eine Messvorrichtung der Restladungsmenge BC der mindestens einen Batterie 1 enthält, dadurch gekennzeichnet, dass die Messvorrichtung gemäß der Erfindung und wie oben beschrieben ist.

Die Batterie 1 ist eine Gleichstromquelle oder ein Gleichstromgenerator, der eine Nennspannung aufweist, die der Eingangsspannung U1 entspricht. Eine oder mehrere Batterien 1 können mit dem Gleichstrom-Gleichstrom-Wandler 2 verbunden sein. Die Batterie 1 ist nicht Teil der erfindungsgemäßen Messvorrichtung, sondern mit einem Eingang E des Gleichstrom-Gleichstrom-Wandlers 2 verbunden.

Der Gleichstrom-Gleichstrom-Schaltwandler 2 hat die Aufgabe, den Wert der Eingangsspannung U1, die von der Batterie 1 kommt, in eine Ausgangsspannung U2 umzuwandeln. Der Gleichstrom-Gleichstrom-Schaltwandler 2 enthält den Eingang E, der elektrisch mit der Batterie oder den Batterien 1 verbunden ist. Er enthält außerdem den Chip des DC/DC-Wandlers 2', der den zusätzlichen Ausgang S' enthält, der elektrisch mit der Impulsformerstufe 8 und andererseits mit einer Induktivität 9 und einer Kapazität 10 stromaufwärts vor der Steuereinheit 3 verbunden ist. Der Gleichstrom-Gleichstrom-Wandler 2 ist elektrisch über den Ausgang S mit der Steuereinheit 3 verbunden.

Die Ausgangsspannung U2 am Ausgang S des Gleichstrom-Gleichstrom-Wandlers 2 wird so gewählt, dass sie an die Merkmale der Steuereinheit 3 angepasst ist. Die Ausgangsspannung U2 ist vorzugsweise niedriger als die Eingangsspannung U1. Der Gleichstrom-Gleichstrom-Wandler 2 enthält vorzugsweise mindestens einen Chip des DC/DC-Wandlers 2' mit einem Schalter, der mit einer vorbestimmten Frequenz geschaltet wird und das Impulsfolgesignal erzeugt, das an den zusätzlichen Ausgang S' geliefert wird. Die Anzahl von Impulsen des Impulsfolgesignals ist für die Anzahl von Schaltvorgängen des Schalters repräsentativ. Der Schalter ist vorzugsweise ein Halbleiter von der Art MOS oder Transistor.

Die Steuereinheit 3 enthält mindestens den Mikrocontroller 4, der das Zählmodul 5 und das Verarbeitungsmodul 7 enthält.

Die Impulsformerstufe 8 hat die Aufgabe, das vom Gleichstrom-Gleichstrom-Wandler 2 kommende Impulsfolgesignal zu formen, indem sie es begrenzt. Die Impulsformerstufe 8 weist vorzugsweise mindestens eine Diode oder zwei Dioden auf, die parallel Kopf bei Fuß montiert sind.

Das Zählmodul 5 hat die Aufgabe, die Anzahl von Impulsen ausgehend vom durch die Impulsformerstufe 8 geformten Impulsfolgesignal zu zählen.

Das Verarbeitungsmodul 7 hat die Aufgabe, die Restladungsmenge BC der mindestens einen Batterie 1 ausgehend von den Kalibrierungsdaten und insbesondere vom Kalibrierungsparameter NC und den Daten des Zählmoduls 5 und insbesondere der vom Zählmodul 5 erhaltenen Anzahl von Impulsen zu bestimmen.

Der Speicher ist elektrisch mit der Steuereinheit 3 und insbesondere mit dem Verarbeitungsmodul 7 verbunden. Der Speicher ist vorzugsweise ein nicht-flüchtiger Speicher, zum Beispiel von der Art Flash-Speicher. Der Speicher kann von der Steuereinheit 3 und/oder der Kommunikationseinheit und/oder der Mensch-Maschine-Schnittstelle kommende Daten speichern. Der Speicher ermöglicht insbesondere, den Kalibrierungsparameter NC für die Bestimmung der Restladungsmenge BC vorab einzuspeichern. Der Speicher ermöglicht zum Beispiel, die Restladungsmenge BC der mindestens einen Batterie 1 einzuspeichern, die vom Verarbeitungsmodul 7 bestimmt wurde.

Die mit der Steuereinheit 3 elektrisch verbundene drahtlose Kommunikationseinheit, vorzugsweise Radiofrequenz und/oder NFC, hat die Aufgabe der Fernkommunikation von Daten, die von der Steuereinheit 3 und/oder vom Speicher kommen.

Die elektrisch mit der Steuereinheit 3 verbundene Mensch-Maschine-Schnittstelle hat die Aufgabe, mit einem Benutzer Daten zu kommunizieren, die von der Steuereinheit 3 und/oder vom Speicher kommen.

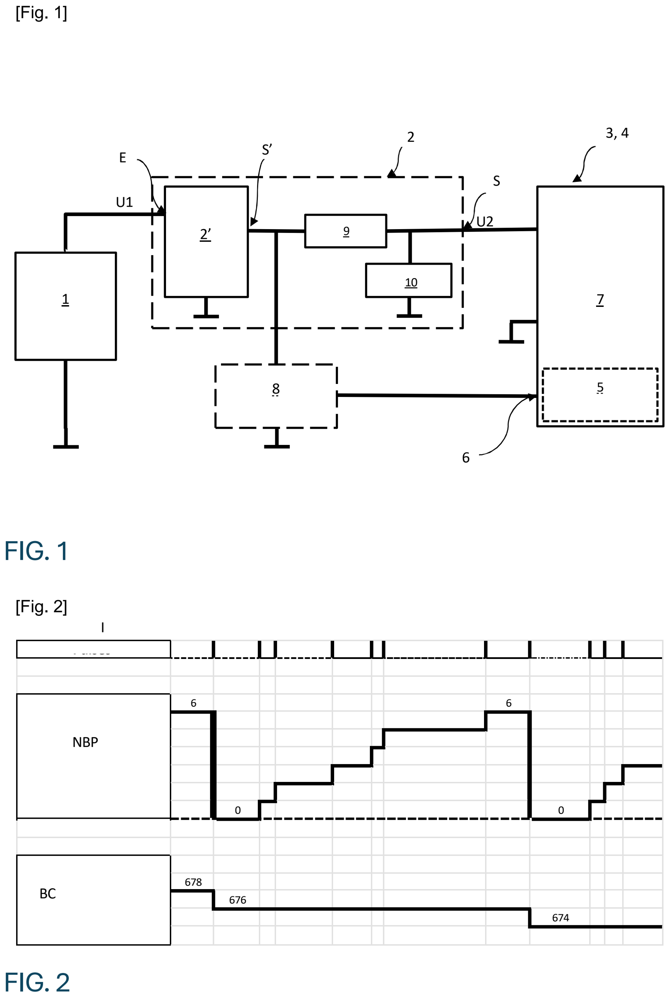

Figur 1 veranschaulicht schematisch die erfindungsgemäße Messvorrichtung. Die Messvorrichtung enthält insbesondere den Gleichstrom-Gleichstrom-Wandler 2, die Impulsformerstufe 8 und die Steuereinheit 3 in Form des Mikrocontrollers 4, der das Zählmodul 5 und das Verarbeitungsmodul 7 enthält. Die erfindungsgemäße Messvorrichtung unterscheidet sich vom bekannten Stand der Technik insbesondere durch das Vorhandensein der Impulsformerstufe 8 und des Zählmoduls 5, das vorzugsweise ursprünglich in den Mikrocontroller 4 integriert ist. Der Gleichstrom-Gleichstrom-Wandler 2 ist im Bereich seines Eingangs E elektrisch mit einer Batterie 1 verbunden, die nicht Teil der Messvorrichtung ist. Der Gleichstrom-Gleichstrom-Wandler 2 ist über den Ausgang S mittels seiner Induktivität 9 und seiner Kapazität 10 elektrisch mit der Steuereinheit 3 verbunden, um die Steuereinheit 3 mit der Ausgangsspannung U2 zu versorgen. Der Chip des DC/DC-Wandlers 2' des Gleichstrom-Gleichstrom-Wandlers 2 ist außerdem im Bereich seines zusätzlichen Ausgangs S' mit der Impulsformerstufe 8 elektrisch verbunden, um das Begrenzen des Impulsfolgesignals zu ermöglichen. Die Impulsformerstufe 8 ist mit der Steuereinheit 3 und insbesondere mit dem Zähleingang 6 des Zählmoduls 5 für die Bestimmung der Anzahl von Impulsen elektrisch verbunden, wobei die erhaltene Anzahl von Impulsen dazu dient, die Restladungsmenge BC der mindestens einen Batterie 1 während der Messdauer zu bestimmen, wie oben beschrieben wurde.

Die Entsprechung zwischen einer bestimmten Menge von von der Batterie oder den Batterien 1 gelieferten Ladungen NBC und der entsprechenden Anzahl von gezählten Impulsen NBP ist für die Funktionsweise der Erfindung bekannt. Es ist möglich, Standardwerte für diese zu verwenden, aber die von der Erfindung gelieferten erwarteten Ergebnisse sind präziser nach einer Kalibrierung oder Abgleichung in der Fabrik und wenn der Kalibrierungsparameter NC bestimmt ist.

Um Betriebsbeispiele des Verarbeitungsmoduls 7 zu erläutern, wird die Variable BCinitial definiert, die der Anzahl von Restladungen in der Batterie oder den Batterien 1 entspricht, in der Fabrik mit dem Wert für eine oder mehrere neue Batterien eingestellt.

Alle nachfolgenden Zahlenwerte NBPC=7, NBCC=2 und BCinitial=678 und in den Figuren sind fiktiv und werden nur zum besseren Verständnis bereitgestellt.

Gemäß einer in Figur 2 veranschaulichten ersten Möglichkeit werden, sobald die Batterie oder die Batterien 1 Strom liefern, Impulse I erzeugt und vom Zählmodul 5 innerhalb des Mikrocontrollers 4 gezählt. Jedes Mal, wenn das Zählmodul 5 den Wert NBPC erreicht, wird es auf 0 zurückgesetzt, und der Wert BC wird um NBCC reduziert. Mit diesem Prinzip ist das Verarbeitungsmodul 7 in der Lage, sehr schnell zu reagieren. Dieses Verarbeitungsprinzip erfordert eine schnelle Reaktivität des Mikrocontrollers 4, aber minimale Rechenressourcen.

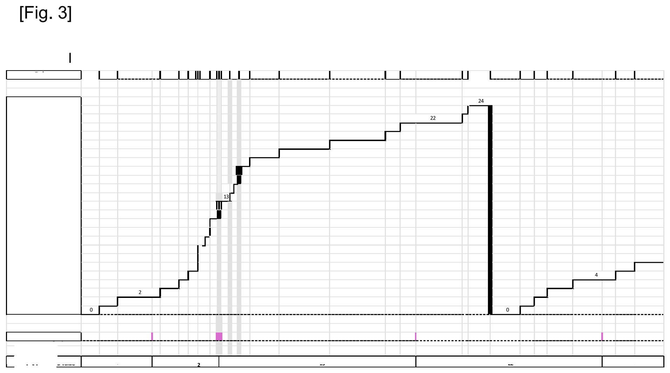

Gemäß einer in Figur 3 veranschaulichten zweiten Möglichkeit werden, sobald die Batterie oder die Batterien 1 Strom liefern, Impulse I erzeugt und vom Zählmodul 5 innerhalb des Mikrocontrollers 4 gezählt. Das Zählmodul 5 wird nie auf 0 zurückgesetzt, es erhöht einfach bis zu seiner maximalen Kapazität und kommt danach automatisch auf 0 zurück. Das Verarbeitungsmodul 7 muss einfach das Zählmodul 5 gelegentlich auslesen und das Ergebnis folgendermaßen verarbeiten:
Die zu einem gegebenen Zeitpunkt Ni erhaltene Anzahl von Impulsen, zu der der Rest der Division der vorhergehenden Iteration hinzugefügt wird, durch die Anzahl von Kalibrierimpulsen NBPC dividieren, dann
- vom vorhergehenden Wert der Restladungsmenge BC der mindestens einen Batterie 1 die Kalibrierungsladungsmenge NBCC subtrahieren, mit der bei der Division erhaltenen ganzen Zahl multiplizieren,
- dann den Rest der Division für die folgende Iteration beibehalten.

Das Verarbeitungsprinzip erfordert etwas mehr Rechenressourcen vom Mikrocontroller 4, ist aber nicht zeitabhängig.

Ein auf Figur 3 basierendes Verarbeitungsbeispiel wird oben beschrieben:
Auslesung N°1
   - Neue Auslesung des Zählmoduls = 2
   - Vorhergehende Auslesung des Zählmoduls = 0
   - Neue Anzahl von wahrgenommenen Impulsen = 2 - 0 = 2
   - Rest der vorhergehenden Verarbeitung = 0
   - Berechnen (Neue Anzahl von wahrgenommenen Impulsen + Rest der vorhergehenden Verarbeitung) / NBPC = (2 + 0) / 7. Man erhält den ganzzahligen Teil = 0 und den Rest = 2
   - Entfernen (NBCC * ganzzahliger Teil) von BC
   Man erhält die Restladungsmenge BC = 678 - 2 * 0 = 678
Auslesung N°2
   - Neue Auslesung des Zählmoduls = 13
   - Vorhergehende Auslesung des Zählmoduls = 2
   - Neue Anzahl von wahrgenommenen Impulsen = 13 - 2 = 11
   - Rest der vorhergehende Verarbeitung = 2
   - Berechnen (Neue Anzahl von wahrgenommenen Impulsen + Rest der vorhergehenden Verarbeitung) / NBPC = (11 + 2) / 7. Man erhält den ganzzahligen Teil = 1 und den Rest = 6
   - Entfernen (NBCC * ganzzahliger Teil) von BC
   Man erhält die Restladungsmenge BC = 678 - 2 * 1 = 676
Auslesung N°3
   - Neue Auslesung des Zählmoduls = 22
   - Vorhergehende Auslesung des Zählmoduls = 13
   - Neue Anzahl von wahrgenommenen Impulsen = 22 - 13 = 9
   - Rest der vorhergehenden Verarbeitung = 6
   - Berechnen (Neue Anzahl von wahrgenommenen Impulsen + Rest der vorhergehenden Verarbeitung) / NBPC = (9 + 6) / 7. Man erhält den ganzzahligen Teil = 2 und den Rest = 1
   - Entfernen (NBCC * ganzzahliger Teil) von BC
   Man erhält die Restladungsmenge BC = 676 - 2 * 2 = 672
Auslesung N°4
   - Neue Auslesung des Zählmoduls = 4
   - Vorhergehende Auslesung des Zählmoduls = 22
   - Neue Anzahl von wahrgenommenen Impulsen = 4 - (22 - 25) = 7 (maximale Kapazität des Zählers = 25)
   - Rest der vorhergehenden Verarbeitung = 1
   - Berechnen (Neue Anzahl von wahrgenommenen Impulsen + Rest der vorhergehenden Verarbeitung) / NBPC = (7 + 1) / 7. Man erhält den ganzzahligen Teil = 1 und den Rest = 1
   - Entfernen (NBCC * ganzzahliger Teil) 2 von BC

Man erhält die Restladungsmenge BC = 672 - 2 * 1 = 670

Selbstverständlich ist die Erfindung nicht auf die beschriebenen und in den beiliegenden Zeichnungen dargestellten Ausführungsformen beschränkt. Änderungen bleiben möglich, insbesondere hinsichtlich der Beschaffenheit der verschiedenen Elemente oder durch Ersatz technischer Äquivalente, ohne dadurch den Schutzbereich der Erfindung zu verlassen.

## Patentansprüche

1. Messvorrichtung der Restladungsmenge (BC) mindestens einer Batterie (1), die mindestens enthält:
- einen Gleichstrom-Gleichstrom-Schaltwandler (2), der konfiguriert ist, eine von der mindestens einen Batterie (1) kommende Eingangsspannung (U1) in eine Ausgangsspannung (U2) umzuwandeln, und an einem zusätzlichen Ausgang (S') ein Impulsfolgesignal liefert, wobei der Gleichstrom-Gleichstrom-Wandler (2) konfiguriert ist, aus der mindestens einen Batterie (1) eine Ladungsmenge während einer Messdauer zu entnehmen, die einer Anzahl von Impulsen des Impulsfolgesignals entspricht,
- eine Steuereinheit (3), die elektrisch mit dem Gleichstrom-Gleichstrom-Wandler (2) verbunden ist und mindestens einen Mikrocontroller (4) enthält,
die Messvorrichtung ist **dadurch gekennzeichnet, dass**:
- der mindestens eine Mikrocontroller (4) ein Zählmodul (5) enthält, das einen Zähleingang (6) hat, und der mindestens eine Mikrocontroller (4) ein elektrisch mit dem Zählmodul (5) verbundenes Verarbeitungsmodul (7) enthält,
- die Messvorrichtung außerdem eine Impulsformerstufe (8) enthält, die elektrisch mit dem zusätzlichen Ausgang (S') und mit dem Zähleingang (6) verbunden und konfiguriert ist, das Impulsfolgesignal zu begrenzen, um es zu formen, damit es mit dem Zähleingang (6) kompatibel ist,
- das Zählmodul (5) konfiguriert ist, die Anzahl von Impulsen des von der Impulsformerstufe (8) geformten Impulsfolgesignals zu zählen, und
- das Verarbeitungsmodul (7) konfiguriert ist, mindestens ausgehend von der vom Zählmodul (5) erhaltenen Anzahl von Impulsen die Restladungsmenge (BC) der mindestens einen Batterie (1) während der Messdauer zu bestimmen.

2. Messvorrichtung nach Anspruch 1, **dadurch gekennzeichnet, dass** die Impulsformerstufe (8) mindestens eine passive analoge Schaltung ohne Steuerlogik enthält.

3. Messvorrichtung nach Anspruch 2, **dadurch gekennzeichnet, dass** die Impulsformerstufe (8) mindestens einen Spannungsbegrenzer enthält.

4. Messvorrichtung nach einem der Ansprüche 1 bis 3, **dadurch gekennzeichnet, dass** das Verarbeitungsmodul (7) einen Kalibrierungsparameter (NC) enthält, der vorzugsweise nach einem Kalibrierungsvorgang in einem Speicher vorab eingespeichert wird, den die Messvorrichtung enthält, der elektrisch mit dem Verarbeitungsmodul (7) verbunden ist, wobei der Kalibrierungsparameter (NC) einer Anzahl von Kalibrierungsimpulsen (NBPC) entspricht, um eine Kalibrierungsladungsmenge (NBCC) aus der mindestens einen Batterie (1) zu entnehmen.

5. Messvorrichtung nach Anspruch 4, **dadurch gekennzeichnet, dass**, während der Messdauer und iterativ, das Zählmodul (5) konfiguriert ist, jedes Mal, wenn der Wert der erhaltenen Anzahl von Impulsen (NBP) die Anzahl von Kalibrierungsimpulsen (NBPC) erreicht, diese Information an das Verarbeitungsmodul (7) zu kommunizieren, damit das Verarbeitungsmodul (7) konfiguriert ist, vom vorhergehenden Wert der Restladungsmenge (BC) der mindestens einen Batterie (1) die Kalibrierungsladungsmenge (NBCC) zu subtrahieren.

6. Messvorrichtung nach Anspruch 4, **dadurch gekennzeichnet, dass**, während der Messdauer und iterativ, das Verarbeitungsmodul (7) konfiguriert ist, den Wert der zu einem gegebenen Zeitpunkt (Ni) erhaltenen Anzahl von Impulsen auszulesen, das Verarbeitungsmodul (7) konfiguriert ist, die zu einem gegebenen Zeitpunkt (Ni) erhaltene Anzahl von Impulsen, zu der der Rest der Division der vorhergehenden Iteration hinzugefügt wird, durch die Anzahl von Kalibrierungsimpulsen (NBPC) zu dividieren, dann vom vorhergehenden Wert der Restladungsmenge (BC) der mindestens einen Batterie (1) die Kalibrierungsladungsmenge (NBCC) zu subtrahieren, mit der bei der Division erhaltenen ganzen Zahl zu multiplizieren, dann den Rest der Division für die folgende Iteration beizubehalten.

7. Messvorrichtung nach einem der Ansprüche 1 bis 6, **dadurch gekennzeichnet, dass** sie außerdem eine drahtlose Kommunikationseinheit enthält, vorzugsweise Radiofrequenz und/oder NFC, die elektrisch mit der Steuereinheit (3) verbunden ist.

8. Messvorrichtung nach einem der Ansprüche 1 bis 7, **dadurch gekennzeichnet, dass** sie außerdem eine Mensch-Maschine-Schnittstelle enthält, die elektrisch mit der Steuereinheit (3) verbunden ist.

9. Fluid- und/oder Wärmeenergiezähler, der mindestens die mindestens eine Batterie (1) und eine Messvorrichtung der Restladungsmenge (BC) der mindestens einen Batterie (1) enthält, **dadurch gekennzeichnet, dass** die Messvorrichtung gemäß einem der Ansprüche 1 bis 8 ist.

10. Festklippbares Modul, das mindestens die mindestens eine Batterie (1) und eine Messvorrichtung der Restladungsmenge (BC) der mindestens einen Batterie (1) enthält, **dadurch gekennzeichnet, dass** die Messvorrichtung einem der Ansprüche 1 bis 8 entspricht.
